# EUROPÄISCHE PATENTSCHRIFT

(11) **EP 1 304 579 B1**
(45) Veröffentlichungstag und Bekanntmachung des Hinweises auf die Patenterteilung: **21.01.2009**
(21) Anmeldenummer: 02017099.9
(22) Anmeldetag: 30.07.2002
(51) Int. Cl.: G01R 31/04, G01R 31/02

(54) **Vorrichtung zum Prüfen elektrischer Leitungen**
Apparatus for testing electrical conductors
Appareil pour tester des conducteurs électriques

(30) Priorität: 08.10.2001 DE 10149502
(43) Veröffentlichungstag der Anmeldung: 23.04.2003
(73) Patentinhaber: Fries, Peter, 63834 Sulzbach (DE)
(72) Erfinder: Fries, Peter, 63834 Sulzbach (DE)
(74) Vertreter: Pöhner, Wilfried Anton, Dr.

(56) Entgegenhaltungen:
- FR-A- 2 649 491
- GB-A- 2 254 439
- US-A- 3 818 329
- US-A- 5 285 163
- US-A- 5 686 840
- US-A- 6 054 849
- UNBEKANNT: "Kabeltester für XLR- und Klinkenstecker" 1. Januar 2001 (2001-01-01), ELVJOURNAL 1/00 , XP009089166
- UNBEKANNT: "PC-Audio-Video-Kabeltester AVK 97" ELVJOURNAL, Bd. 3(97, 1. März 1997 (1997-03-01), XP009089167

## Beschreibung

Die Erfindung betrifft eine Vorrichtung zum Prüfen elektrischer Leitungen, die mittels eines Male- und eines Female-Steckers miteinander verbindbar oder mit den genannten Steckern ausrüstbar sind, wobei die Vorrichtung an ihrer Eingangs- und Ausgangsseite jeweils mit mindestens einem elektrische Kontakte aufweisenden Steckverbinder ausgestattet ist, wobei der eingangs- und der ausgangsseitige Steckverbinder jeweils komplementär zuelnander ausgebildet sind
und jeweils die gleiche Anzahl an Kontakten aufweisen und in gleicher Anzahl Messkontakte vorhanden sind, und zwischen je einem Kontakt des eingangsseitigen Steckverbinders, je einem Messkontakt und je einem Kontakt des ausgangsseitigen Steckverbinders jeweils eine elektrisch leitende Verbindung herstellbar ist, und ein Messgerät mit Meßkontakten verbunden ist.

Vorrichtungen der genannten Art werden zur Überprüfung von elektrischen Leitungen eingesetzt. Der Anwendungsbereich umfaßt dabei sowohl Signalleitungen, als auch solche Leitungen, die zur Übertragung von elektrischen Leistungen dienen. Der Prüfung liegt die Aufgabe zugrunde, nach dem Herstellen eines elektrischen Anschlusses festzustellen, ob Leitungen und welche der Leitungen mit einer Spannung oder einem elektrischen signal beaufschlagt sind. Das gleiche Problem kann sich auch steilen, wenn nachträglich ein Fehler im Leitungssystem auftritt und eine Überprüfung aller Leitungen erforderlich macht.

Bei der Überprüfung einzelner Adern oder Leitungen mit wenigen Adern ist die genannte Aufgabe relativ einfach zu lösen, da die Adern meist ohne Problem gezielt heraus gegriffen werden können. Dennoch ist auch in diesen Fällen bei den häufig hierfür angewandten provisorischen Prüfanördrungen die Gefahr von elektrischen Kurzschlüssen nicht ganz auszuschießen.

Wesentlich schwieriger gestaltet sich der Prüfvorgang jedoch, wenn Kabel mit vielen Adern vorliegen, oder mit Anschlußsteckern versehen sind, die einen Zugriff auf einzelne Adern unmöglich machen. Derartige Randbedingungen treten insbesondere in der Signalverarbeitung elektronischer Geräte, wie PC, Monitor, Fernseher oder Drucker - um nur einige zu nennen - auf. Bei diesen Anwendungsfällen sind in der Regel Kabel im Einsatz, die eine Vielzahl von Adern aufweisen.

Die Überprüfung eines elektrischen Anschlusses erfolgt nach dem Stand der Technik mit Meßgeräten, bei denen in der Regel jeweils eine elektrisch leitende Verbindung vom Meßgerät zur der zu untersuchenden Ader herdestellt wird. Bei Anwendungen mit einer Vielzahl von Kabeln und Leitungen wird dieser Vorgang sooft wiederholt wie Adern vorhanden sind, die Überprüfung von Kabeln dieser Art ist dementsprechend mit hohem Aufwand verbunden. Häufig bilden die einzelnen Adern im Bereich ihrer Anschlüsse auch ein regelrechtes "Kabelverhau", das den Überblick über die einzelnen Verbindungen erschwert und Fehler beim Prüfen wahrscheinlich macht. Vorrichtungen nach dem Stand der Technik bieten für die genannte Problemstellung daher keine befriedigende Lösung an.

Auf aktuellem Stand der Technik beschreiben die im folgenden genannten Dokumente jeweils Messadapter, die mit einem male-Stecker und einem female-Stecker ausgerüstet sind und zwischen eine geöffnete Steckverbindung eingesteckt werden.

In US 5 686 840 wird ein Messadapter genannt, der grundsätzlich eine "Kontinuität", also einen geschlossenen, elektrischen Durchgang, zwischen Eingangs- und Ausgangskabel aufweist. Nachteilig ist, dass keine Ströme in den Leitern gemessen werden können und, dass im Messadapter keine selektive Verbindung nur für einen Teil der Adern möglich ist, um so Teil-funktionen zu prüfen.

Im ELVjournal 1/00 auf Seite 56 bis 58, XP 009 089 166 wird ein Kabel-tester beschrieben, dem jegliche Messpunkte auf dem Gerät fehlen. Die Verbindungen zwischen Eingangs- und Ausgangsstecker sind fest vorge-geben und können vom Nutzer nicht verändert werden. Das Gerät ist nicht als Messhilfe gedacht, sondern als reiner Durchgangsprüfer für Kabelsätze.

Anders als die Erfindung kann es nicht in eine geöffnete Steckverbindung eingeschteift werden, die dann mittels des Gerätes wieder ganz oder tell-weise geschlossen werden kann, um so komplett und selektiv die Funktion nicht nur des Kabels selbst sondern auch der darüber geführten Spannung gen, Ströme und Signale zu prüfen.

Im ELVjournal 3/97 wird auf Seite 60 bis 62, XP 009 089 167 ein komplexer PC-Audio-Video-Kabeltester mit zahlreichen, aktiven elektronischen Bauteilen präsentiert. Nachteilig ist, dass er noch einen Personalcomputer zur Funktion der erforderlichen Software benötigt. Messbuchsen sind nicht vorhanden. Ebenso wie der vorgenannte Kabeltester ist auch dieses Gerät nur zum Prüfen von Kabelsätzen, nicht aber zum Einstecken in ein anderes Gerät und zu dessen Prüfung verwendbar.

Das Patent US 5,285,163 nennt einen elektrischen Kabeldurchgangstester, dem ebenfalls jegliche Messpunkte auf dem Gerät fehlen. Seine Nachteile sind, dass die Verbindungen zwischen Eingangs- und Ausgangsstecker sind fest verdrahtet sind und vom Nutzer nicht verändert werden können. Auch dieses Gerät ist nicht als Messhilfe gedacht, sondern als reiner Durchgangsprüfer für Kabelsätze.

Auch das Patent US 6,054,849 stellt ein Gerät vor, dass ein reiner Kabelprüfer ist. Nachteilig ist, dass es nach dem Einstecken der beiden Enden eines Kabels keine Messpunkte gibt, die von außen zugänglich sind. Schon deshalb ist die Integration des Kabelprüfers in ein anderes Gerät, um nicht nur die Verbindungskabel auf Durchgängigkeit zu prüfen, sondern auch die Messwerte der durch dieses Kabel üblicherweise fließenden Ströme und dabei auftretenden Spannungen zu erfassen, unmöglich.

Das Gebrauchsmuster DE 85 25 949.7 beschreibt einen Zwischenstecker mit erhöhter Schutzart, der in eine bestehende Steckverbindung eingefügt wird, um "einzelne Leitungen des mehrpoligen Steckverbinders nachträglich anzuzapfen und ggfs. für Diagnose- oder Messzwecke mit einem entsprechenden Gerät verbinden zu können". Im Zwischenstecker wird eine permanente und vom Nutzer nicht veränderbare Verbindung zwischen den beiden Steckern hergestellt. Jede einzelne Ader wird "angezapft" und als prinzipiell T-förmige Verbindung herausgeführt. Das Gebrauchsmuster lässt offen, wie an den herausgeführten Kabelenden Prüfgeräte angeschlossen werden können.

Hiervon ausgehend hat sich die Erfindung die Aufgabe gestellt, eine Vorrichtung anzugeben, welche die dargelegte Überprüfung von elektrischen Leitungen in einfacher Weise und unter Anwendung einfacher und daher kostengünstiger Mittel ermöglicht.

Erfindungsgemäß wird diese Aufgabe dadurch gelöst, daß die genannten Verbindungen durch Elemente zum Öffnen und Schließen eines Leiterkreises, nämlich Schalter und/oder Brücken und/oder Steckverbindungen öffenbar und schließbar sind.

Die vorgeschlagene Vorrichtung wird als Meßadapter zum Prüfen elektrischer Leitungen eingesetzt, die mittels eines Male- und eines Female-Steckers miteinander verbindbar oder mit den genannten Steckern ausrüstbar sind. Eine bestehende elektrische Verbindung dieser Art wird zur Überprüfung mit vorliegendem Adapter getrennt und die Vorrichtung gemäß vorliegender Erfindung zwischengeschaltet. Zu diesem Zweck wird das eine Ende der aufgetrennten Leitung an den eingangsseitigen Steckverbinder der Vorrichtung angeschlossen, während der ausgangsseitige Steckverbinder der Vorrichtung mit dem zweiten Ende der aufgetrennten Leitung verbunden wird. Der eingangsseitige und ausgangsseitige Steckverbinder des Meßadapters sind aus diesem Grund komplementär zueinander ausgebildet und weisen jeweils die gleiche Anzahl von elektrischen Kontakten auf.

Die vorgeschlagene Vorrichtung weist zudem Meßkontakte in gleicher Anzahl auf, von denen jeweils ein Kontakt mit je einem Kontakt des eingangsseitigen und des ausgangsseitigen Steckverbinders elektrisch leitend verbunden ist. Infolge dieser konstruktiven Ausgestaltung läßt sich eine Überprüfung der über den Meßadapter geschleusten Adern oder Leitungen einfach dadurch durchführen, daß die Meßsonde eines Meßgerätes sukzessiv mit den genannten Meßkontakten der vorgeschlagenen Vorrichtung in Verbindung gebracht wird. Über die interne Verbindung innerhalb des Meßadapters wird dann - einem wesentlichen Gedanken der Erfindung entsprechend - jeweils eine Verbindung zu einer Ader des zu untersuchenden Kabels hergestellt. Nach erfolgter Messung wird der Meßadapter wieder ausgebaut und die geprüfte Leitung mittels ihrer Steckverbinder wieder geschlossen.

Die Überprüfung liefert primär eine Aussage darüber, ob an der betreffenden Ader eine Spannung oder ein Signal anliegt. Die Messung erfolgt dabei an dem über den Meßadapter geschlossenen Leiter in der Regel gegenüber Erdpotential. Die vorgeschlagene Vorrichtung kann darüber hinaus auch bei der Messung weiterer Kenngrößen, wie beispielsweise des Widerstandes, eingesetzt werden.

Neben der dargelegten Betriebsart, bei der eine Überprüfung der über den Adapter geschlossenen Leitung erfolgt, kann der Meßadapter auch dazu verwendet werden, Messungen an offenen Leitungen vorzunehmen. In diesem Fall wird das zweite Ende der aufgetrennten Leitung nicht an die ausgangsseitige Steckverbindung der vorgeschlagenen Vorrichtung angeschlossen. Die Messungen liefern dann die Leerlaufwerte der jeweils untersuchten Adern.

Der Vorgang bei der Überprüfung elektrischer Leitungen gestaltet sich mit der vorgeschlagenen Vorrichtung sehr einfach. Dementsprechend wird der Aufwand bei der Überprüfung gegenüber der Arbeitsweise mit bekannten Meßgeräten erheblich reduziert, wobei die Übersichtlichkeit der Prüfanordnung gleichzeitig erhöht wird. Ebenfalls als Vorteil anzusehen ist, daß der apparative Aufwand zur Durchführung der genannten Prüfaufgaben sehr gering ausfällt.

Der Einsatzbereich des vorgeschlagenen Meßadapters läßt sich noch erweitern, wenn die internen Verbindungen zwischen dem jeweiligen eingangsseitigem Kontakt, ausgangsseitigem Kontakt und Meßkontakt nicht fest verdrahtet sind, sondern gezielt zu schließen und öffnen sind. Gemäß einem Merkmal der Erfindung sind innerhalb der internen Verbindungen daher Elemente zum Öffnen und Schließen eines Leiterkreises, wie beispielsweise
- Schalter
- Brücken
- Steckverbindungen
vorgesehen. Beispielsweise lassen sich durch Anordnung von mehrpoligen Steckverbindern zwischen den Kontakten des ein- und ausgangsseitigen Steckverbinders und/oder den Meßkontakten und den Kontakten des ausgangsseitigen Steckverbinders jeweils nur Gruppen von Kontakten aktivieren, wenn man die Verbindung zwischen diesen Kontakten mittels Steckverbinder herstellt, während die übrigen Kontakte nicht miteinander verbunden werden. Denkbar ist auch eine Änderung der 1:1-Verbindung zwischen ein- und ausgangsseitigen Kontakten, wenn die Anwendung dies erfordert. Dabei läßt sich im allgemeinen Fall, durch Einbau der entsprechenden Steckverbinder, auch erreichen, daß jeder Meßkontakt wahlfrei mit jedem eingangsseitigen oder jedem ausgangsseitigen Kontakt verbunden werden kann. Anstelle der genannten Steckverbinder können auch Brücken oder Schalter für den gleichen Zweck vorgesehen werden.

Dem Ziel eines möglichst großen Anwendungsbereichs dient auch eine Ausgestaltung der erfindungsgemäßen Vorrichtung, bei welcher für den eingangsseitigen und/oder ausgangsseitigen Steckverbinder jeweils ein Adapter vorgesehen ist, mittels dessen der genannte Steckverbinder jeweils an
- Steckverbinder anderer Bauart
- und/oder Steckverbinder mit einer abweichenden Anzahl von Kontakten
anschließbar ist. Prinzipiell unerheblich ist dabei, ob der Adapter in Form eines Doppelsteckers mit den eingangsseitig und ausgangsseitig geforderten unterschiedlichen Anschlüssen ausgebildet ist oder mittels zweier Stecker realisiert ist, die durch eine mehradriges Kabel miteinander verbunden sind. Die genannten Adapter erlauben, in vorteilhafter Weise Verbindungen der vorgeschlagenen Prüfvorrichtung zu Kabeln herzustellen, die mit Steckern anderer Bauart ausgestattet sind.

Bei einer anderen Ausführungsform, die dem gleichen Zweck dient, ist bereits an der Prüfvorrichtung selbst eingangs- und/oder ausgangsseitig je ein Satz Steckerverbinder unterschiedlicher Bauart vorgesehen. Dabei sind einander entsprechende Kontakte der Steckverbinder parallel miteinander verschaltet. Da der an der Vorrichtung zum Einbau von Steckverbindern verfügbare Platz naturgemäß begrenzt ist, ist der genannte Satz auf die jeweils gängigen Ausführungen von Steckverbindern beschränkt. Alternativ hierzu lassen sich aus dem Meßadapter auch parallel miteinander verschaltete Kabel herausführen, welche mit Steckverbindern unterschiedlicher Bauart bestückt sind.

Die Meßkontakte der vorgeschlagenen Vorrichtung sind gemäß einem Merkmal der Erfindung als Buchsen ausgebildet, die vorzugsweise in einem Raster angeordnet sind. Eine als Lochplatte ausgebildete Gehäusewandung mit jeweils dem Buchsendurchmesser und -abstand entsprechenden Bohrungen deckt die Buchsen ab. Bei einer Messung wird durch die jeweilige Bohrung hindurch der Meßfühler des eingesetzten Meßgerätes in die betreffende Buchse eingeschoben und hierdurch der Kontakt zu der zu untersuchenden Leitung hergestellt.

Bei einer vorteilhaften Ausführungsform des Meßadapters sind Meßkontakte nach bestimmten Kriterien zu Gruppen zusammengefaßt, wobei den einzelnen Gruppen eingangs- und/oder ausgangsseitig vorzugsweise jeweils ein eigener Steckverbinder zugeordnet ist. Durch diese Ausgestaltung ist es möglich, Messungen gezielt auf Untermengen von Leitungen zu beschränken.

Ebenso von Vorteil ist es, wenn auf dem Gehäuse der Vorrichtung Markierungen, vorzugsweise farbliche Markierungen, für die Meßkontakte vorgesehen sind. Die zu Gruppen zusammengefaßten Meßkontakte sind dabei vorzugsweise durch die gleiche bzw. farblich gleiche Markierung gekennzeichnet.

Durch beide Maßnahmen - Gruppierung und farbliche Kennzeichnung - wird für den Anwender die Übersicht über die zur Messung vorgesehenen Meßkontakte erhöht. Insbesondere bei Vorrichtungen mit einer großen Anzahl von Meßkontakten, die mitunter weit mehr als hundert Kontakte umfassen kann, ist eine verbesserte Übersichtlichkeit von Vorteil.

Nach einem Merkmal der Erfindung ist vorgesehen, ein- und dieselbe Vorrichtung sowohl zur Prüfung von Signalleitungen als auch zur Prüfung von Leitungen, die zur Leistungsübertragung vorgesehen sind, einzusetzen. Die dargelegte Ausführung der ein- und ausgangsseitigen Steckverbinder, insbesondere die Zusammenfassung von Meßkontakten zu Gruppen und die Zuordnung von separaten Steckverbindern zu den Gruppen, ebenso die erfindungsgemäß vorgesehenen Adapter zum Anschluß der vorgeschlagenen Vorrichtung an Stecker unterschiedlicher Bauart ermöglichen diesen universellen Einsatz des Meßadapters.

Weitere Einzelheiten, Merkmale und Vorteile der Erfindung lassen sich dem nachfolgenden Teil der Beschreibung entnehmen. In diesem Teil wird ein Ausführungsbeispiel des erfindungsgemäßen Meßadapters anhand einer Zeichnung näher erläutert. Die Figuren zeigen:
- Figur 1:: Aufsicht auf den Meßadapter
- Figur 2a:: Verlauf der Leiterbahnen auf der Oberseite der Platine
- Figur 2b:: Verlauf der Leiterbahnen auf der Unterseite der Platine

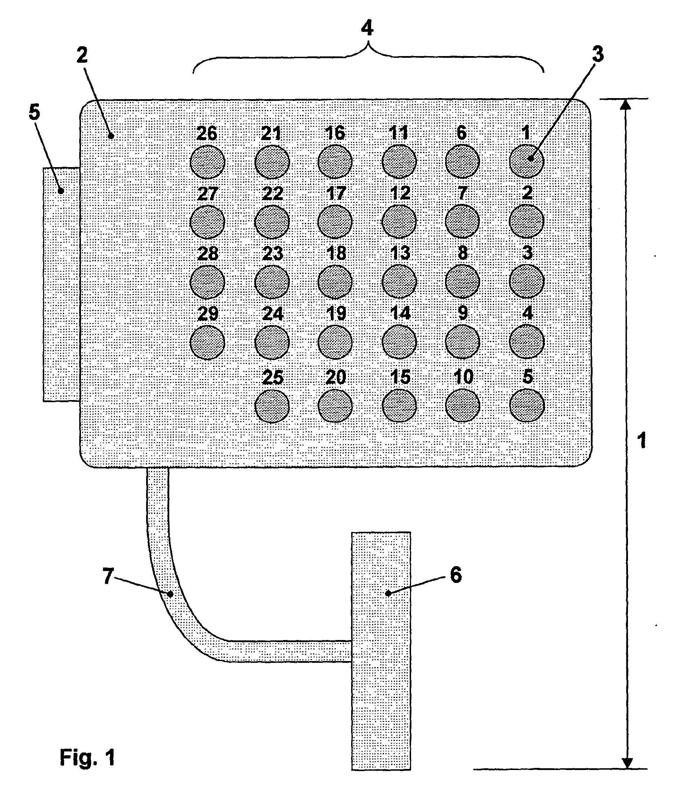

Die in Figur 1 wiedergegebene Aufsicht des Meßadapters 1 zeigt die Gehäusewand 2, welche die Zugänge 3 zu den als Buchsen ausgebildeten Meßkontakten 4 aufweist. Im vorliegenden Fall ist ein Meßadapter mit neunundzwanzig, jeweils mit Ziffern gekennzeichneten Meßkontakten 4 wiedergegeben. Dementsprechend weist auch der eingangsseitige Steckverbinder 5 und der ausgangsseitige Steckverbinder 6 ebenfalls jeweils neunundzwanzig Kontakte auf. Ein- und ausgangsseitige Steckverbinder 5, 6 sind komplementär zu einander ausgebildet, der eingangsseitige als Male-Stecker in Form einer Messerleiste, der ausgangseitige als Female-Stecker in Form eines Buchsensteckers. Bei vorliegender Ausführungsform ist der Eingangsstecker 5 fest in das Gehäuse eingebaut, während der Ausgangsstecker 6 an einem Kabel 7 befestigt ist. Jeweils ein Kontakt des Male-Steckers 5, des Female-Steckers 6 und der Meßkontakte 4 sind miteinander leitend verbunden.

Bei Durchführung einer Prüfung wird die Steckverbindung des zu prüfenden Kabels (nicht dargestellt) getrennt, der Female-Stecker des Kabels mit der Eingangsseite 5 des Meßadapters 1 und der Male-Stecker des Kabels mit der Ausgangsseite 6 des Meßadapters 1 verbunden. In einen der Meßkontakte 4 wird dann die (nicht dargestellte) Prüfsonde des Meßgerätes eingeführt und über die interne Verbindung innerhalb des Meßadapters 1 die Verbindung zu einer Ader des zu untersuchenden Kabels hergestellt.

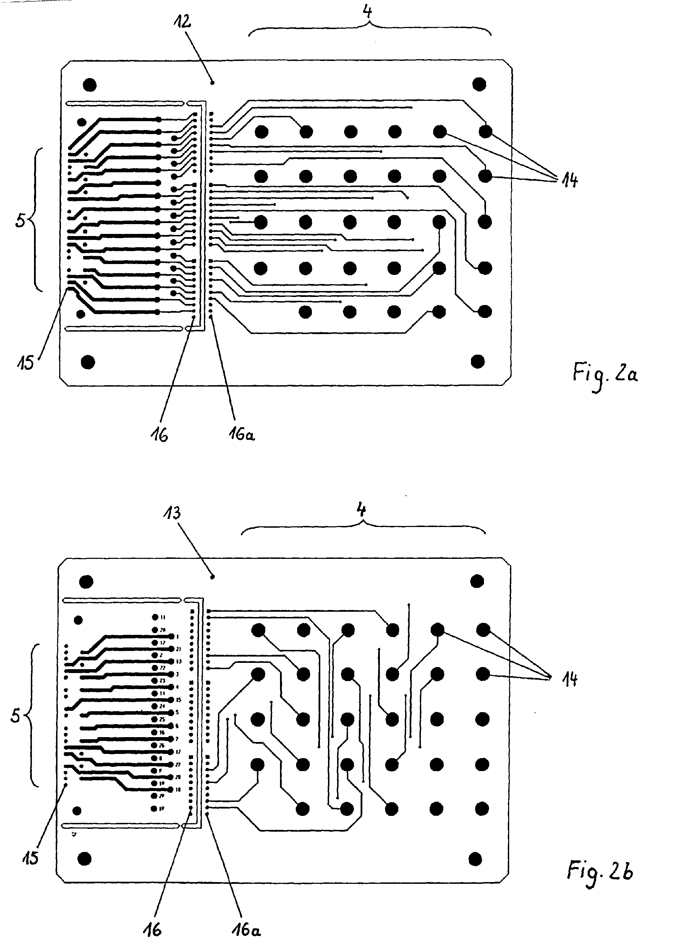

Figur 2 gibt die Leiterplatine zur Verschaltung der einzelnen Kontakte wieder, wobei in Figur 2a die Oberseite 12 , in Figur 2b die Unterseite 13 der Platine dargestellt ist. Wie den Figuren zu entnehmen ist, sind die Kontakte 14 der Meßkontakte 4 und die Kontakte 15 des eingangsseitigen Steckverbinders 5 nicht direkt miteinander verbunden, sondern jeweils an einen Satz von drei Steckverbindern 16 bzw.16a angeschlossen. Nicht dargestellt ist das Kabel 7 aus Figur 1, das an seinem einen Ende zu 16 und 16a komplementär ausgebildete Steckverbinder aufweist, während das andere Ende nach außen geführt ist und den ausgangsseitigen Steckverbinder 6 trägt. Die elektrisch leitende Verbindung zwischen je einem Kontakt des Eingangssteckers 5, der Meßkontakte 4 und des Ausgangssteckers 6 wird bei vorliegender Ausführungsform über die Steckverbinder 16, 16a und deren komplementäre Gegenstücke hergestellt.

Bei vorliegender Ausführungsform ist dem Satz von Steckverbindern 16 bzw. 16a entsprechend eine Einteilung der Meßkontakte 4 in drei Gruppen vorgenommen. Diese Gruppen können jeweils für sich aktiviert werden, in dem der betreffende Steckverbinder 16, 16a mit seinem komplementären Stecker verbunden wird.

## Patentansprüche

1. Vorrichtung zum Prüfen elektrischer Leitungen, die mittels eines Male- und eines Female-Steckers miteinander verbindbar oder mit den genannten Steckern ausrüstbar sind, wobei die Vorrichtung (1) an ihrer Eingangs- und Ausgangsseite jeweils mit mindestens einem elektrische Kontakte aufweisenden Steckverbinder (5, 6) ausgestattet ist,
wobei
der eingangs- und der ausgangsseitige Steckverbinder (5, 6)
- jeweils komplementär zueinander ausgebildet sind
- und jeweils die gleiche Anzahl an Kontakten (15) aufweisen
- und in gleicher Anzahl Meßkontakte (4) vorhanden sind,
- und zwischen je einem Kontakt (15) des eingangsseitigen Steckverbinders (5), je einem Meßkontakt (14) und je einem Kontakt des ausgangsseitigen Steckverbinders (6) jeweils eine elektrisch leitende Verbindung herstellbar ist,
- und ein Messgerät mit Meßkontakten (14) verbunden werden kann,
**dadurch gekennzeichnet, dass**
die genannten Verbindungen durch Elemente zum Öffnen und Schließen eines Leiterkreises, nämlich
- Schalter und/oder
- Brücken und/oder
- Steckverbindungen (16, 16a)
öffenbar und schließbar sind.

2. Vorrichtung zum Prüfen elektrischer Leitungen nach Anspruch 1,
**dadurch gekennzeichnet, dass**
jeder Messkontakt (4) wahlfrei mittels Steckverbinder (5,6) mit jedem eingangsseitigen Kontakt (15) oder jedem ausgangsseitigen Kontakt verbunden werden kann.

3. Vorrichtung nach Anspruch 1, **dadurch gekennzeichnet, dass**
- für den eingangsseitigen (5) und/oder ausgangsseitigen Steckverbinder (6) jeweils ein Adapter vorgesehen ist, mittels dessen der genannte Steckverbinder jeweils an
- Steckverbinder anderer Bauart
- und/oder Steckverbinder mit einer abweichenden Anzahl von Kontakten
anschließbar ist.

4. Vorrichtung nach Anspruch 1, **dadurch gekennzeichnet, dass**
- eingangsseitig und/oder ausgangsseitig mindestens 2 parallel zueinander angeordnete Steckverbinder unterschiedlicher Bauart vorgesehen sind.

5. Vorrichtung nach Anspruch 1, **dadurch gekennzeichnet, dass**
- die Messkontakte (14) jeweils als Buchsen ausgebildet sind,
- die vorzugsweise in einem Raster angeordnet sind.

6. Vorrichtung nach Anspruch 1, **dadurch gekennzeichnet, dass**
- die Messkontakte (14) nach bestimmten Kriterien zu Gruppen zusammengefasst sind,
- und den einzelnen Gruppen eingangs- und/oder ausgangsseitig vorzugsweise jeweils ein eigener Steckverbinder zugeordnet ist.

7. Vorrichtung nach Anspruch 6, **dadurch gekennzeichnet, dass**
- auf dem Gehäuse (2) der Vorrichtung Markierungen, vorzugsweise farbliche Markierungen, für die genannten Messkontakte (14) vorgesehen sind,
- wobei die genannten Gruppen vorzugsweise gleiche bzw farblich gleiche Markierungen aufweisen.

## Claims

1. Device for testing electrical lines, which can be connected together by means of a male and a female plug or can be fitted with the aforementioned plugs, the device (1) being equipped at its input and output sides with a plug connector (5, 6), in each case, having at least one electrical contact,
- the input-side and output-side plug connectors (5, 6) being in each case designed so as to be complementary to one another
- and having the same number of contacts (15),
- and an identical number of measurement contacts (4),
and an electrically conducting connection being producible between one contact (15) of the input-side plug connector (5) in each case, one measurement contact (14) in each case and one contact in each case of the output-side plug connector (6), and a measurement device being connected to the measurement contacts (14) ,
**characterised in that**
the aforementioned contacts can be opened and closed by means of elements for opening and closing a conductor circuit, namely
- Switches and/or
- Bridges and/or
- Plug connections (16, 16a).

2. Device for testing electrical lines according to claim 1, **characterised in that**
each measurement contact (4) can be freely by means of plug connectors (5, 6) to each input-side contact (15) or each output-side contact.

3. Device according to claim 1, **characterised in that**
- for the input-side (5) and/or output-side plug connector (6), one adaptor in each case is provided, by means of which the aforementioned plug connector in each case can be connected to a plug connectors of different designs
and/or to plug connectors with a deviating number of contacts.

4. Device according to claim 1, **characterised in that**
at least 2 plug connectors of different designs, which are arranged so as to be parallel to one another, are provided at the input-side and output-side.

5. Device according to claim 1, **characterised in that** the
measurement contacts (14) are in each case designed as sockets, which are preferably arranged in a matrix.

6. Device according to claim 1, **characterised in that**
- measurement contacts (14) are collected together into groups
- and the individual groups are preferably assigned to an own plug connector at their input-side and/or output-side.

7. Device according to claim 6, **characterised in that**
marks, preferably coloured marks, for the aforementioned measurement contacts (14) are preferably provided on the housing (2) of the device.
the aforementioned groups preferably having the same marks or the same coloured marks.

## Revendications

1. Dispositif destiné à contrôler les câbles électriques pouvant être reliés les uns aux autres au moyen d'une fiche mâle et d'une fiche femelle ou pouvant être équipés des fiches nommées, sachant que ce dispositif (1) est à chaque fois configuré, du côté de son entrée et du côté de sa sortie, avec au moins un connecteur à fiche (5, 6) présentant des contacts électriques,
sachant que
• les connecteurs à fiche (5, 6) côté entrée et côté sortie
• sont configurés de façon complémentaire l'un par rapport à l'autre
• et présentent à chaque fois le même nombre de contacts (15)
• et qu'il y a le même nombre de contacts de mesure (4),
• et qu'une liaison électrique conductrice peut être établie à chaque fois entre chaque contact (15) du côté du connecteur à fiche (5), chaque contact de mesure (14) et d'un contact du connecteur à fiche côté entrée, et d'un contact côté sortie,
• et pouvant être relié à un appareil avec des contacts de mesure (14)
**caractérisé par le fait que**
les liaisons nommées peuvent être ouvertes ou fermées par des éléments destinés à ouvrir et à fermer un circuit de conducteurs, à savoir
• des interrupteurs et/ou
• des cavaliers et/ou
• des liaisons par fiche (16, 16a).

2. Dispositif destiné à contrôler les câbles électriques selon la revendication 1 **caractérisé par le fait que** chaque contact de mesure (4) peut être relié au choix au moyen d'un connecteur à fiche (5, 6), à chaque contact côté entrée (15) ou à chaque contact côté sortie.

3. Dispositif selon la revendication 1 **caractérisé par le fait**
• **qu'**un adaptateur est prévu à chaque fois pour le connecteur à fiche côté entrée (5) et/ou côté sortie, au moyen duquel le connecteur à fiche nommé peut être raccordé à
■ des connecteurs à fiche de construction différente
■ et/ou des connecteurs à fiche avec un nombre de contacts différents.

4. Dispositif selon la revendication 1 **caractérisé par le fait**
• **qu'**au moins 2 connecteurs à fiche de construction différente disposés parallèlement l'un par rapport à l'autre sont prévus.

5. Dispositif selon la revendication 1 **caractérisé par le fait**
• **que** les contacts de mesure (14) sont formés à chaque fois en tant que douilles,
• qui sont disposées de préférence dans une trame.

6. Dispositif selon la revendication 1 **caractérisé par le fait**
• **que** les contacts de mesure (14) sont rassemblés à chaque fois en groupes d'après certains critères,
• et **qu'**un connecteur à fiche propre est attribué de préférence aux différents groupes côté entrée et/ou côté sortie.

7. Dispositif selon la revendication 6 **caractérisé par le fait**
• **que** des marquages sont prévus sur le boîtier (2) du dispositif, de préférence des marquages de couleurs, pour les contacts de mesure (14) nommés,
• sachant que les groupes nommés présentent de préférence les mêmes marquage, respectivement les mêmes couleurs.
